# EUROPEAN PATENT APPLICATION

(11) **EP 4 194 584 A1**
(43) Date of publication of application: **14.06.2023**
(21) Application number: 22808923.1
(22) Date of filing: 20.07.2022
(51) Int. Cl.: C23C 16/46, C23C 16/455, C23C 16/52, C23C 16/30, H01L 21/02, H01L 21/67

(54) **SEMICONDUCTOR GROWTH DEVICE AND WORKING METHOD THEREOF**

(30) Priority: 27.10.2021 CN 202111251445
(71) Applicant: Suzhou Everbright Photonics Co., Ltd., Suzhou, Jiangsu 215011 (CN)
(72) Inventor: WANG, Jun, Suzhou, Jiangsu 215011 (CN); CHENG, Yang, Suzhou, Jiangsu 215011 (CN); XIAO, Xiao, Suzhou, Jiangsu 215011 (CN); GUO, Yintao, Suzhou, Jiangsu 215011 (CN); GOU, Yudan, Suzhou, Jiangsu 215011 (CN)
(74) Representative: Lavoix
(86) International application number: PCT/CN2022/106856
(87) International publication number: WO 2023/071311

(57) **Abstract**

The present application provides a semiconductor growth device and an operation method thereof. The semiconductor growth device includes: a reaction chamber; a heating base arranged in the reaction chamber, where the heating base includes a first heating area and a second heating area arranged around a periphery of the first heating area, a heating temperature of the first heating area is greater than a heating temperature of the second heating area, and a surface of the second heating area is adapted for placing a substrate; and a first spray unit and a second spray unit arranged at a top of the reaction chamber, where the first spray unit is arranged above the first heating area, and the second spray unit is arranged above the second heating area, where the first spray unit includes at least a first pipe, the first pipe is adapted for introducing a first gas source, the second spray unit includes at least a second pipe, the second pipe is adapted for introducing a second gas source, and a decomposition temperature of the first gas source is greater than a decomposition temperature of the second gas source. The optimal growth temperature range of the semiconductor growth device is reduced, and the use range of the device is expanded.

## Description

This application claims priority to Chinese patent application No. 202111251445.3, entitled "SEMICONDUCTOR GROWTH DEVICE AND OPERATION METHOD THEREOF", filed with the China National Intellectual Property Administration on October 27, 2021, the disclosure of which is hereby incorporated by reference in its entirety.

### TECHNICAL FIELD

The present application relates to the field of semiconductor technologies, and specifically to a semiconductor growth device and an operation method thereof.

### BACKGROUND

Semiconductor devices such as semiconductor lasers, high electron mobility transistors, and photodetectors are often manufactured using epitaxial growth techniques, of which the two most common epitaxial technologies are metal organic chemical vapor deposition (MOCVD) and molecular beam epitaxy (MBE). Compared with MBE, MOCVD is more suitable for large-scale commercial production due to its advantages such as high growth stability, easy maintenance, and high yield, and its market share has been increasing year by year in recent years. Although MOCVD has the above advantages over MBE, the optimal growth temperature range of a semiconductor growth device used in MOCVD is significantly higher than that used in MBE. Therefore, many materials that need to be grown at low temperatures cannot be grown by MOCVD, which largely limits the range of materials that can be grown by MOCVD.

In summary, there is an urgent need to reduce the temperature of the optimal growth temperature range of the semiconductor growth device used for MOCVD and to expand the use range of the device.

### SUMMARY OF THE INVENTION

Therefore, a technical problem to be resolved by the present application is to overcome the problem that a semiconductor growth device in existing technologies has a relatively high optimal growth temperature range and a relatively narrow use range, and a semiconductor growth device and an operation method thereof are provided.

The present application provides a semiconductor growth device, including: a reaction chamber; a heating base arranged in the reaction chamber, where the heating base includes a first heating area and a second heating area arranged around a periphery of the first heating area, a heating temperature of the first heating area is greater than a heating temperature of the second heating area, and a surface of the second heating area is adapted for placing a substrate; and a first spray unit and a second spray unit arranged at a top of the reaction chamber, where the second spray unit is arranged around a periphery of the first spray unit, the first spray unit is arranged above the first heating area, and the second spray unit is arranged above the second heating area, where the first spray unit includes at least a first pipe, the first pipe is adapted for introducing a first gas source, the second spray unit includes at least a second pipe, the second pipe is adapted for introducing a second gas source, and a decomposition temperature of the first gas source is greater than a decomposition temperature of the second gas source.

Optionally, the device further includes: a first flow rate adjustment member disposed on a transport path of the first pipe; and a second flow rate adjustment member disposed on a transport path of the second pipe.

Optionally, the device further includes: an isolation member disposed at the top of the reaction chamber and arranged between the first spray unit and the second spray unit.

Optionally, the heating base includes: a first subbase, where the first subbase includes a central area and an edge area surrounding the central area, and an accommodating groove is provided in at least a top of the central area; and a second subbase arranged in the accommodating groove, where the second subbase forms the first heating area, and the first subbase arranged around a periphery of the second subbase forms the second heating area.

Optionally, a heat insulating member is disposed between the second subbase and the first subbase.

Optionally, the accommodating groove is arranged in the top of the central area; and the semiconductor growth device further includes a rotating shaft, and the rotating shaft is fastened to the first subbase below the second subbase.

Optionally, the accommodating groove penetrates the central area, the accommodating groove includes a first subgroove area and a second subgroove area arranged above the first subgroove area, a cross-sectional size of the second subgroove area is greater than a cross-sectional size of the first subgroove area, the heat insulating member is disposed on a groove bottom of the second subgroove area, and the heat insulating member is arranged around the first subgroove area.

Optionally, the accommodating groove further includes a third subgroove area arranged below the second subgroove area; and the semiconductor growth device further includes: a fastening pin arranged in the third subgroove area, where the fastening pin is fastened to the first subbase around a periphery of the third subgroove area; and a rotating shaft, where the rotating shaft is arranged below the fastening pin and connected to the fastening pin.

Optionally, the fastening pin is an insulation fastening pin.

Optionally, a spacing between the first spray unit and the first heating area ranges from 8 mm to 20 mm; and a spacing between the second spray unit and the second heating area ranges from 8 mm to 20 mm.

Optionally, a material of the heating base includes graphite or molybdenum.

Optionally, the first spray unit further includes a third pipe spaced apart from the first pipe, the third pipe is adapted for introducing a third gas source, a group source type of the third gas source is the same as a group source type of the second gas source, and a flow rate for introducing the third gas source into the third pipe is less than a flow rate for introducing the first gas source into the first pipe; and the second spray unit further includes a fourth pipe spaced apart from the second pipe, the fourth pipe is adapted for introducing a fourth gas source, a group source type of the fourth gas source is the same as a group source type of the first gas source, and a flow rate for introducing the fourth gas source into the fourth pipe is less than a flow rate for introducing the second gas source into the second pipe.

Optionally, the first gas source includes a group-V gas source, and the fourth gas source includes a group-V gas source; and the second gas source includes a group-III gas source, and the third gas source includes a group-III gas source.

Optionally, the decomposition temperature of the first gas source is greater than or equal to a decomposition temperature of the fourth gas source.

Optionally, the device further includes: a third flow rate adjustment member disposed on a transport path of the third pipe; and a fourth flow rate adjustment member disposed on a transport path of the fourth pipe.

Optionally, the device further includes: a first transition heating area to an N^{th} transition heating area arranged between the first heating area and the second heating area; and a first transition spray unit to an N^{th} transition spray unit arranged between the first spray unit and the second spray unit, where N is an integer greater than or equal to 1; and a k^{th} transition spray unit is arranged above a k^{th} transition heating area, and k is an integer greater than or equal to 1 and less than or equal to N.

Optionally, the device further includes: a first radio frequency unit arranged below the first heating area; and a second radio frequency unit arranged below the second heating area, where a radio frequency power of the first radio frequency unit is greater than a radio frequency power of the second radio frequency unit.

The present application further provides an operation method of a semiconductor growth device, including: placing a substrate on a surface of a second heating area; introducing a first gas source into a first pipe and introducing a second gas source into a second pipe after the substrate is placed on the surface of the second heating area, where the second gas source is decomposed into a second decomposed gas above the second heating area, and the first gas source is decomposed into a first decomposed gas above the first heating area; transporting the first decomposed gas to an area above the second heating area; and growing a film layer on a surface of the substrate by a reaction between the second decomposed gas and the first decomposed gas above the second heating area.

Optionally, the first spray unit further includes a third pipe spaced apart from the first pipe; and the second spray unit further includes a fourth pipe spaced apart from the second pipe; and the operation method of the semiconductor growth device further includes: simultaneously introducing the first gas source into the first pipe and introducing a third gas source into the third pipe, where a group source type of the third gas source is the same as a group source type of the second gas source, and a flow rate for introducing the third gas source into the third pipe is less than a flow rate for introducing the first gas source into the first pipe; and simultaneously introducing the second gas source into the second pipe and introducing a fourth gas source into the fourth pipe, where a group source type of the fourth gas source is the same as a group source type of the first gas source, and a flow rate for introducing the fourth gas source into the fourth pipe is less than a flow rate for introducing the second gas source into the second pipe.

Optionally, after the substrate is placed on the surface of the second heating area, the heating base is rotated around a central axis of the heating base.

The technical solutions of the present application have the following beneficial effects.

In the semiconductor growth device provided in the technical solutions of the present application, the heating base includes a first heating area and a second heating area arranged around a periphery of the first heating area, and a heating temperature of the first heating area is greater than a heating temperature of the second heating area; a surface of the second heating area is adapted for placing a substrate; a first spray unit and a second spray unit are arranged at a top of the reaction chamber, the second spray unit is arranged around a periphery of the first spray unit, the first spray unit is arranged above the first heating area, and the second spray unit is arranged above the second heating area; and the first spray unit includes at least a first pipe, the first pipe is adapted for introducing a first gas source, the second spray unit includes at least a second pipe, the second pipe is adapted for introducing a second gas source, and a decomposition temperature of the first gas source is greater than a decomposition temperature of the second gas source. The second gas source is decomposed into a second decomposed gas above the second heating area. Because the heating temperature of the first heating area is greater than the heating temperature of the second heating area, the first heating area can promote the decomposition of the first gas source on a surface of the first heating area. The first gas source is mainly decomposed into a first decomposed gas on the surface of the first heating area. The first decomposed gas moves to a surface of the substrate along with an airflow to react with the second decomposed gas. Therefore, a film layer with relatively high quality can be obtained by reacting the first decomposed gas and the second decomposed gas on the second heating area with a relatively low temperature. Therefore, the optimal growth temperature range of the semiconductor growth device is reduced, and the use range of the device is expanded.

Next, the first gas source is adapted for entering the reaction chamber from above the first heating area, and the second gas source is adapted for entering the reaction chamber from above the second heating area. Therefore, before the first gas source and the second gas source reach the surface of the substrate, most of the first gas source and most of the second gas source are not mixed in advance, so that pre-reactions are reduced, thereby improving the utilization of materials.

Optionally, the first flow rate adjustment member is used for adjusting the flow rate of the first gas source introduced into the first pipe, so that the flow rate of the first gas source entering the reaction chamber is selectively adjusted. The second flow rate adjustment member is used for adjusting the flow rate of the second gas source introduced into the second pipe, so that the flow rate of the second gas source entering the reaction chamber is selectively adjusted.

Optionally, the first spray unit further includes a third pipe, the third pipe is adapted for introducing a third gas source, a group source type of the third gas source is the same as a group source type of the second gas source, and a flow rate for introducing the third gas source into the third pipe is less than a flow rate for introducing the first gas source into the first pipe. The second spray unit further includes a fourth pipe, the fourth pipe is adapted for introducing a fourth gas source, a group source type of the fourth gas source is the same as a group source type of the first gas source, and a flow rate for introducing the fourth gas source into the fourth pipe is less than a flow rate for introducing the second gas source into the second pipe. The function of the third pipe includes: controlling a gas flow field in the reaction chamber by adjusting a total gas flow rate in the third pipe. The function of the fourth pipe includes: controlling a gas flow field in the reaction chamber by adjusting a total gas flow rate in the fourth pipe.

Optionally, the device further includes: a third flow rate adjustment member disposed on a transport path of the third pipe; and a fourth flow rate adjustment member disposed on a transport path of the fourth pipe. The third flow rate adjustment member is used for adjusting the flow rate of the third gas source introduced into the third pipe, so that the flow rate of the third gas source entering the reaction chamber is selectively adjusted. The fourth flow rate adjustment member is used for adjusting the flow rate of the fourth gas source introduced into the fourth pipe, so that the flow rate of the fourth gas source entering the reaction chamber is selectively adjusted.

Optionally, the device further includes: an isolation member disposed at the top of the reaction chamber and arranged between the first spray unit and the second spray unit. The isolation member is used for preventing the mixture of gas sources from the first spray unit and the second spray unit inside a spray head.

Optionally, a heat insulating member is disposed between the second subbase and the first subbase. The heat insulating member is used for preventing heat in the second subbase from diffusing into the first subbase, to form a stable temperature difference between the second subbase and the first subbase.

### BRIEF DESCRIPTION OF THE DRAWINGS

To describe the technical solutions in specific embodiments of the present application or the prior art more clearly, the following briefly introduces the accompanying drawings required for describing the specific embodiments or the prior art. Apparently, the accompanying drawings in the following description show some embodiments of the present application, and a person of ordinary skill in the art may still derive other drawings from these accompanying drawings without creative efforts.
FIG. 1 is a schematic structural diagram of a semiconductor growth device according to an embodiment of the present application;
FIG. 2 is a schematic structural diagram of a semiconductor growth device according to another embodiment of the present application;
FIG. 3 is a schematic diagram of a heating base, a heat insulating member, a rotating shaft, a fastening pin, a first radio frequency unit, and a second radio frequency unit in a semiconductor growth device according to still another embodiment of the present application; and
FIG. 4 is a flowchart of an operation method of a semiconductor growth device according to an embodiment of the present application.

### DETAILED DESCRIPTION

There are three main types of MOCVD reaction chambers, namely, a planetary air cushion rotating horizontal reaction chamber, a high speed turntable reaction chamber, and a tightly coupled spray reaction chamber.

In the planetary air cushion rotating horizontal reaction chamber, when a group-III reaction gas source and a group-V reaction gas source are used, the group-III reaction gas source and the group-V reaction gas source enter the reaction chamber through a three-layer flow nozzle of an upper lid, respectively, and are forced by a grille to flow horizontally in a radial pattern toward an outer edge in a 360-degree annular space between a base on which a substrate is placed and a ceiling and flow out through a perforated quartz side ring. The base is a graphite base. The ceiling is a quartz ceiling or a graphite ceiling. This flow method eliminates sidewalls of the horizontal reaction chamber, and accordingly a sidewall effect is eliminated. The ceiling and the base are very close to each other, suppressing convective vortices to obtain a laminar flow. The group-V reaction gas source enters from the upper and lower layers of the three-layer flow nozzle, and the group-III reaction gas source enters through the middle layer. A water cooling unit is provided at the center of the upper lid, which facilitates the suppression of pre-reactions. A plurality of graphite planetary turntables for placing a substrate are provided on the base. The plurality of graphite planetary turntables are uniformly distributed in an annular shape. The rotation (revolution) of the base is driven directly by a magnetic fluid seal shaft, while the graphite planetary turntables are driven by an air cushion rotation technology. A substrate revolves with the base and rotates with the graphite planetary turntables, to implement a planetary rotation of the substrate with both rotation and revolution, thereby obtaining a uniform growth rate over the entire surface of the substrate and improving the uniformity between substrates.

In a high speed turntable reaction chamber, a reaction gas source is injected by a specially designed gas flow flange nozzle at the top. The base rotates at a high speed (the rotational speed ranges from 700 r/min to 1500 r/min), and exhaust gas flows out from the bottom. A pump effect generated by the high speed rotation of the base is used to suppress a thermal convection vortex easily caused by a large distance between the nozzle and the base in a vertical reaction chamber. This pump effect is the result of the combined effect of a viscous force of a fluid and a centrifugal force generated by rotation. Under the action of the viscous force of the fluid, a layer of gas near the surface of a substrate rotates along with the base. Under the action of the centrifugal force, the gas is continuously thrown in a radial direction to an edge of the base. Meanwhile, the gas above the substrate flows in an axial direction to the surface of the substrate to replenish the lost gas. At an appropriate high rotational speed, the rotation of the base allows the gas in the reaction chamber to flow smoothly through the base without causing any eddy piston flow, and also improves the uniformity of temperature distribution and the temperature gradient above the base, thereby greatly improving the uniformity of the growth rate. A hydride source and a metal organic (MO) source may be injected separately from the gas flow flange nozzle, and the MO source may enter the reaction chamber through an inner injection zone, a middle injection zone, and an outer injection zone that allow independent adjustment and metering to improve the uniformity of a growth layer. Gas exit flow rates of different nozzles may be matched to avoid eddies.

The tightly coupled spray reaction chamber is characterized by a small distance ranging from 10 mm to 20 mm between a spray head of a reaction gas source and the base. From the perspective of hydrodynamics, the shortening of the distance between the spray head and the base is beneficial in suppressing the formation of eddies above the base. However, when the distance is reduced, the surface of the spray head is exposed to heat radiation, causing high temperature and deposition. Therefore, cooling is required. The spray head has a number of regularly arranged stainless steel pipes (orifices) with an inner diameter of 0.6 mm, and the density of the orifices reaches 15.5/cm². Spacings between the orifices need to be small enough to allow the group-III reaction gas source and the group-V reaction gas source respectively injected from two groups of orifices spaced apart to be fully mixed before the gas sources flow through short distances to reach the base. A total area of the orifices of the spray head needs to be large enough to cover the entire base. The spray head distributes the reaction gases uniformly over the substrate on the surface of the base, so that the concentrations of the reaction gas reaching the points on the substrate are approximately the same, forming a boundary layer with a uniform thickness, thereby forming a uniform epitaxial layer.

A uniform epitaxial layer can be obtained by using all the three types of reaction chambers mentioned above through unique designs. Based on the design of a gas flow field of a reaction chamber, some or even all of the group-III reaction gas source and the group-V reaction gas source need to reach the center of the base first before flowing in a diameter direction of the base toward an edge of the base. However, these three reaction chambers are generally designed to minimize a temperature difference in the diameter direction of the base. That is, the temperature at the center of the base is approximately the same as the temperature at the edge of the base, so that the cracking of the material generally occurs above the base. It is worth mentioning here that the molar flow rate of the group-V reaction gas source introduced into the reaction chamber is usually greater than that of the group-III reaction gas source because the pyrolysis of the group-V reaction gas source is usually more difficult, and the ratio between the two usually ranges from 10 to 10,000.

Due to the design concept of the three reaction chambers, the final result is that all three devices have only a relatively narrow growth temperature range. Specifically, the temperature of the base cannot be excessively high, or otherwise the high strain thin layer material undergoes relaxation due to a high temperature. In addition, the growth temperature of the base also cannot be excessively low, or otherwise a reaction gas source, especially the group-V reaction gas source, fails to thermally decompose effectively before reaching the top of a substrate on the surface of the base. As a result, the amount of the group-V reaction gas source actually participating in the reaction is insufficient, causing reduced growth quality. The narrow growth temperature range, especially the inability to grow materials at relatively low temperatures, severely limits the variety of materials that can be grown by MOCVD.

To overcome the above-mentioned difficulties in a conventional reaction chamber, through painstaking practice, the inventor invented a semiconductor growth device, which, through a special design, effectively reduces the optimal growth temperature range of the semiconductor growth device, so that many materials that can only be grown at low temperatures can be grown, thereby expanding the use range of the semiconductor growth device. The core of the improvement of the semiconductor growth device is that a dual-temperature zone is intentionally arranged inside a reaction chamber, so that after entering the reaction chamber, a gas source decomposes at a high temperature first before being transported to the surface of a substrate for low-temperature growth.

The following clearly and completely describes the technical solutions in the present application with reference to the accompanying drawings. Apparently, the described embodiments are some rather than all of the embodiments of the present application. All other embodiments obtained by persons of ordinary skill in the art based on the embodiments of the present application without creative efforts shall fall within the protection scope of the present application.

In the description of the present application, it needs to be understood that orientation or location relationships indicated by terms "center", "up", "down", "left", "right", "vertical", "horizontal", "inside", and "outside" are based on orientation or location relationships shown in the accompanying drawings, and are only used to facilitate description of the present application and simplify description, but are not used to indicate or imply that the apparatuses or elements must have specific orientations or are constructed and operated by using specific orientations, and therefore, cannot be understood as a limit to the present application. In addition, the terms "first", "second", and "third" are used only for description, but are not intended to indicate or imply relative importance.

In addition, the technical features involved in different embodiments of the present application described below can be combined with each other as long as they do not constitute a conflict between them.

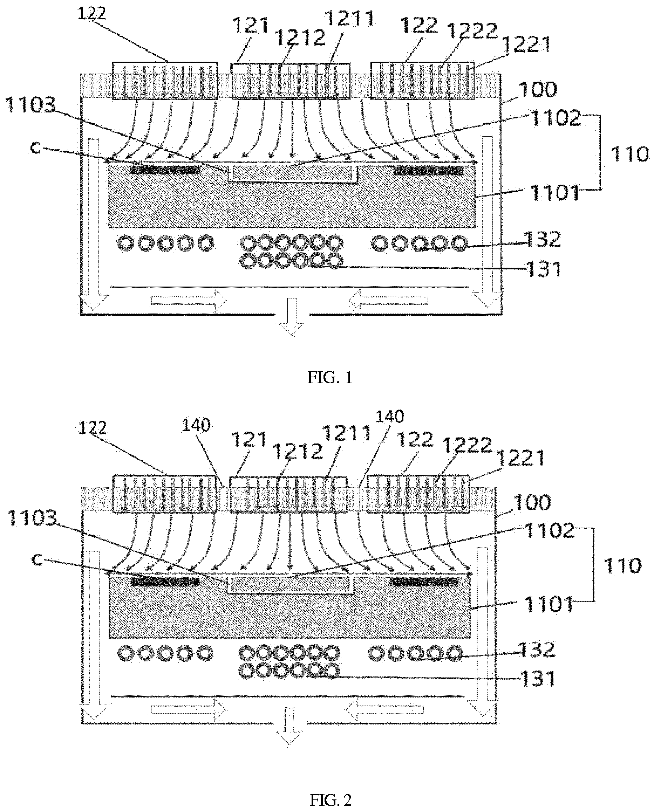

An embodiment of the present application provides a semiconductor growth device, referring to FIG. 1, including:
a reaction chamber 100;
a heating base 110 arranged in the reaction chamber 100, where the heating base 110 includes a first heating area and a second heating area arranged around a periphery of the first heating area, a heating temperature of the first heating area is greater than a heating temperature of the second heating area, and a surface of the second heating area is adapted for placing a substrate C; and
a first spray unit 121 and a second spray unit 122 arranged at a top of the reaction chamber 100, where the second spray unit 122 is arranged around a periphery of the first spray unit 121, the first spray unit 121 is arranged above the first heating area, and the second spray unit 122 is arranged above the second heating area; and
the first spray unit 121 includes at least a first pipe 1211, the first pipe 1211 is adapted for introducing a first gas source, the second spray unit 122 includes at least a second pipe 1221, the second pipe 1221 is adapted for introducing a second gas source, and a decomposition temperature of the first gas source is greater than a decomposition temperature of the second gas source.

In this embodiment, the semiconductor growth device is used for MOCVD.

In this embodiment, the second gas source is decomposed into a second decomposed gas above the second heating area. Because the heating temperature of the first heating area is greater than the heating temperature of the second heating area, the first heating area can promote the decomposition of the first gas source on a surface of the first heating area. The first gas source is mainly decomposed into a first decomposed gas on the surface of the first heating area. The first decomposed gas moves to a surface of the substrate C along with an airflow to react with the second decomposed gas. Therefore, a film layer with relatively high quality can be obtained by reacting the first decomposed gas and the second decomposed gas on the second heating area with a relatively low temperature. Therefore, the optimal growth temperature range of the semiconductor growth device is reduced, and the use range of the device is expanded. Next, the first gas source is adapted for entering the reaction chamber from above the first heating area, and the second gas source is adapted for entering the reaction chamber from above the second heating area. Therefore, before the first gas source and the second gas source reach the surface of the substrate, most of the first gas source and most of the second gas source are not mixed in advance, so that pre-reactions are reduced, thereby improving the utilization of materials.

In this embodiment, the first spray unit 121 is only arranged above the first heating area, and the second spray unit 122 is only arranged above the second heating area.

It needs to be noted that in other embodiments, that the first spray unit 121 is arranged above the first heating area and the second spray unit 122 is arranged above the second heating area may be that the first spray unit is mainly arranged right above the first heating area, a part of the first spray unit is further arranged above a part of the second heating area, the second spray unit is mainly arranged right above the second heating area, and a part of the second spray unit is further arranged above a part of the first heating area.

The semiconductor growth further includes: a first flow rate adjustment member (not shown) disposed on a transport path of the first pipe 1211; and a second flow rate adjustment member (not shown) disposed on a transport path of the second pipe 1221.

The first flow rate adjustment member is used for adjusting the flow rate of the first gas source introduced into the first pipe 1211, so that the flow rate of the first gas source entering the reaction chamber 100 is selectively adjusted. The second flow rate adjustment member is used for adjusting the flow rate of the second gas source introduced into the second pipe 1221, so that the flow rate of the second gas source entering the reaction chamber 100 is selectively adjusted.

In this embodiment, the second heating area is arranged around a periphery of the first heating area, and the second spray unit 122 is uniformly distributed in a circumferential direction of the first spray unit 121.

The first spray unit 121 further includes a third pipe 1212 spaced apart from the first pipe 1211. The third pipe 1212 is adapted for introducing a third gas source, where a group source type of the third gas source is the same as a group source type of the second gas source, and a flow rate adapted for introducing the third gas source into the third pipe 1212 is less than a flow rate adapted for introducing the first gas source into the first pipe 1211.

The second spray unit 122 further includes a fourth pipe 1222 spaced apart from the second pipe 1221. The fourth pipe 1222 is adapted for introducing a fourth gas source, where a group source type of the fourth gas source is the same as a group source type of the first gas source, and a flow rate adapted for introducing the fourth gas source into the fourth pipe 1222 is less than a flow rate adapted for introducing the second gas source into the second pipe 1221.

The function of the third pipe 1212 includes: adjusting a gas flow field distribution in the reaction chamber and a concentration distribution of a gas source in an interior space of the reaction chamber. The function of the fourth pipe 1222 includes: adjusting a gas flow field distribution in the reaction chamber and a concentration distribution of a gas source in an interior space of the reaction chamber.

In an embodiment, a distance between the first pipe 1211 and the third pipe 1212 ranges from 5 mm to 30 mm.

In an embodiment, a distance between the second pipe 1221 and the fourth pipe 1222 ranges from 5 mm to 30 mm.

In this embodiment, the first spray unit 121 only includes the first pipe 1211 and the third pipe 1212, and the second spray unit 122 only includes the second pipe 1221 and the fourth pipe 1222.

It needs to be noted that in other embodiments, the first spray unit only includes the first pipe, and the second spray unit only includes the second pipe. In other embodiments, the first spray unit may include more pipes, and the second spray unit may include more pipes.

In this embodiment, the first gas source includes a group-V gas source, and the fourth gas source includes a group-V gas source. In this embodiment, the second gas source includes a group-III gas source, and the third gas source includes a group-III gas source.

In other embodiments, the first gas source and the fourth gas source may be gas sources of other groups, and the second gas source and the third gas source may be gas sources of other groups.

The decomposition temperature of the first gas source is greater than or equal to the decomposition temperature of the fourth gas source. In an embodiment, the decomposition temperature of the first gas source is equal to the decomposition temperature of the fourth gas source. The same material can be selected for the first gas source and the fourth gas source. For example, the material of the first gas source is arsine (AsH₃), and the material of the fourth gas source is arsine (AsH₃). In another embodiment, the decomposition temperature of the first gas source is greater than the decomposition temperature of the fourth gas source. Different materials are selected for the first gas source and the fourth gas source. For example, the material of the first gas source is arsine (AsH₃), and the material of the fourth gas source is tert-butylarsine (TBAs).

The decomposition temperature of the first gas source is greater than the decomposition temperature of the fourth gas source, so that the utilization efficiency of group-V gas sources are further improved, and the background carrier concentration of the materials is reduced.

The semiconductor growth further includes: a third flow rate adjustment member (not shown) disposed on a transport path of the third pipe 1212; and a fourth flow rate adjustment member (not shown) disposed on a transport path of the fourth pipe 1222.

The third flow rate adjustment member is used for adjusting the flow rate of the third gas source introduced into the third pipe 1212, so that the flow rate of the third gas source entering the reaction chamber 100 is selectively adjusted. The fourth flow rate adjustment member is used for adjusting the flow rate of the fourth gas source introduced into the fourth pipe 1222, so that the flow rate of the fourth gas source entering the reaction chamber 100 is selectively adjusted.

In another embodiment, referring to FIG. 2, the semiconductor growth device further includes: an isolation member 140 disposed at the top of the reaction chamber 100 and arranged between the first spray unit 121 and the second spray unit 122.

The function of the isolation member 140 includes preventing the mixture of gas sources from the first spray unit 121 and the second spray unit 122 inside a spray head. The material of the isolation member 140 is stainless steel.

In an embodiment, the shape of the isolation member 140 is annular.

The material of the heating base 110 includes graphite or molybdenum.

Referring to FIG. 1 and FIG. 2, the heating base 110 includes: a first subbase 1101, where the first subbase 1101 includes a central area and an edge area surrounding the central area, an accommodating groove 1103 is provided in at least a top of the central area of the first subbase 1101, and specifically, the accommodating groove 1103 is arranged in the top of the central area of the first subbase 1101; and a second subbase 1102 arranged in the accommodating groove 1103, where the second subbase 1102 forms the first heating area, and the first subbase 1101 arranged around a periphery of the second subbase 1102 forms the second heating area.

In an embodiment, the material of the first subbase 1101 is graphite, and the material of the second subbase 1102 is graphite. In other embodiments, the material of the first subbase 1101 is molybdenum, and the material of the second subbase 1102 is molybdenum.

The semiconductor growth device further includes a rotating shaft. The rotating shaft is fastened to the bottom of the heating base 110. The rotating shaft is used for driving the heating base 110 to rotate around the central axis of the heating base 110. Specifically, the rotating shaft is fastened to the first subbase 1101 below the second subbase 1102. In an embodiment, the rotational speed of the rotating shaft ranges from 10 revolutions per minute to 120 revolutions per minute.

Referring to FIG. 1 and FIG. 2, the semiconductor growth device further includes: a first radio frequency unit 131 arranged below the first heating area; and a second radio frequency unit 132 arranged below the second heating area, where a radio frequency power of the first radio frequency unit 131 is greater than a radio frequency power of the second radio frequency unit 132. The first radio frequency unit 131 heats the first heating area by using an induced current, and the second radio frequency unit 132 heats the second heating area by using an induced current. The radio frequency power of the first radio frequency unit 131 and the radio frequency power of the second radio frequency unit 132 can be separately controlled.

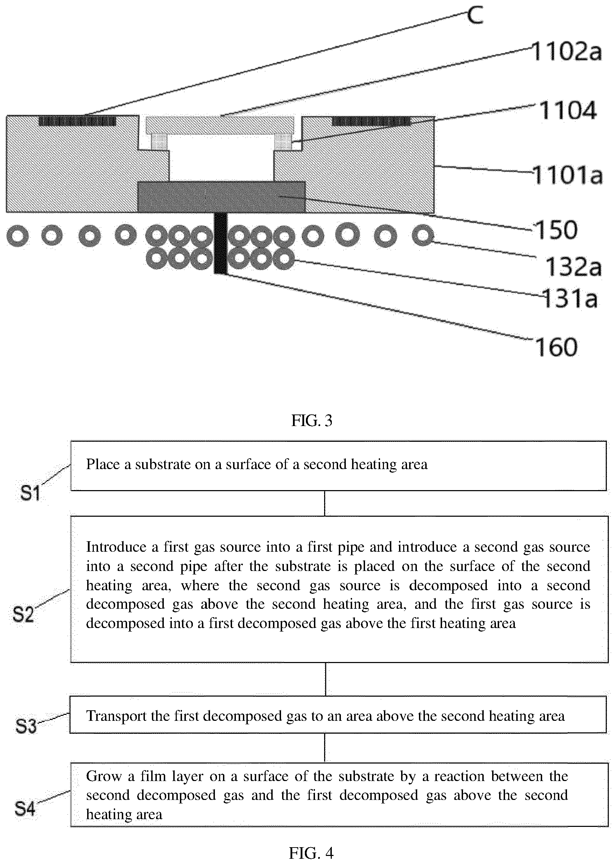

In still another embodiment, referring to FIG. 3, the heating base includes a first subbase 1101a and a second subbase 1102a. The first subbase 1101a includes a central area and an edge area surrounding the central area. A heat insulating member 1104 is disposed between the second subbase 1102a and the first subbase 1101a. The heat insulating member 1104 is used for preventing heat in the second subbase 1102a from diffusing into the first subbase 1101a, to form a stable temperature difference between the second subbase 1102a and the first subbase 1101a. For example, the temperature difference between the second subbase 1102a and the first subbase 1101a is stabilized between 20 degrees Celsius to 100 degrees Celsius. The material of the heat insulating member 1104 includes quartz.

Referring to FIG. 3, the accommodating groove penetrates the central area of the first subbase 1101a. The second subbase 1102a is arranged in the accommodating groove. The accommodating groove includes a first subgroove area and a second subgroove area arranged above the first subgroove area. A cross-sectional size of the second subgroove area is greater than a cross-sectional size of the first subgroove area. The heat insulating member 1104 is disposed on a groove bottom of the second subgroove area. The heat insulating member 1104 is arranged around the first subgroove area. Referring to FIG. 3, the accommodating groove further includes a third subgroove area arranged below the second subgroove area; and the semiconductor growth device further includes: a fastening pin 150 arranged in the third subgroove area, where the fastening pin 150 is fastened to the first subbase 1101a around a periphery of the third subgroove area; and a rotating shaft 160, where the rotating shaft 160 is arranged below the fastening pin 150 and connected to the fastening pin 150. In an embodiment, the rotational speed of the rotating shaft 160 ranges from 10 revolutions per minute to 120 revolutions per minute.

The fastening pin 150 is an insulation fastening pin. The material of the insulation fastening pin includes quartz.

In an embodiment, a spacing between the first spray unit and the first heating area ranges from 8 mm to 20 mm; and a spacing between the second spray unit and the second heating area ranges from 8 mm to 20 mm. If the spacing between the first spray unit and the first heating area is excessively large, a gas flow field in the reaction chamber becomes unstable. If the spacing between the first spray unit and the first heating area is excessively small, effective heat dissipation cannot be implemented between the two spray units, and pre-reactions between gas source materials are intensified. If the spacing between the second spray unit and the second heating area is excessively large, a gas flow field in the reaction chamber becomes unstable. If the spacing between the second spray unit and the second heating area is excessively small, effective heat dissipation cannot be implemented between the two spray units, and pre-reactions between gas source materials are intensified.

Referring to FIG. 3, the semiconductor growth device further includes: a first radio frequency unit 131a arranged below the first heating area; and a second radio frequency unit 132a arranged below the second heating area, where a radio frequency power of the first radio frequency unit 131a is greater than a radio frequency power of the second radio frequency unit 132a. The radio frequency power of the first radio frequency unit 131a and the radio frequency power of the second radio frequency unit 132a can be separately controlled. The first radio frequency unit 131a heats the second subbase 1102a by using an induced current and does not significantly affect the temperature of the first subbase 1101a, and the second radio frequency unit 132a heats the second heating area by using an induced current. The insulation fastening pin has poor electrical conductivity performance and thermal conductivity performance. Therefore, the insulation fastening pin is not heated and can prevent thermal conduction between the second subbase 1102a and the first subbase 1101a.

It needs to be noted that when the accommodating groove penetrates the central area of the first subbase 1101a, a first heating wire may be used in place of the first radio frequency unit 131a, and a second heating wire may be used in place of the second radio frequency unit 132a.

In this embodiment, no other heating area is provided between the first heating area and the second heating area, and no other spray unit is provided between the first spray unit and the second spray unit.

It needs to be noted that in other embodiments, the semiconductor growth device may further include: a first transition heating area to an N^{th} transition heating area arranged between the first heating area and the second heating area; and a first transition spray unit to an N^{th} transition spray unit arranged between the first spray unit and the second spray unit, where N is an integer greater than or equal to 1, and is, for example, 1, 2, 3, 4 or an integer greater than 4.

A k^{th} transition spray unit is arranged above a k^{th} transition heating area, and k is an integer greater than or equal to 1 and less than or equal to N.

The heating temperatures of the first transition heating area to the N^{th} transition heating area are all greater than the heating temperature of the second heating area and less than the heating temperature of the first heating area.

In an embodiment, when N is greater than or equal to 2, a (j+1)^{th} heating area is arranged around a periphery of a j^{th} transition heating area, j being an integer greater than or equal to 1 and less than or equal to N-1.

In an embodiment, when N is greater than or equal to 2, the heating temperature decreases from the first transition heating area to the N^{th} transition heating area.

Correspondingly, an embodiment of the present application further provides an operation method of a semiconductor growth device, referring to FIG. 4, including:
S 1: placing a substrate on a surface of a second heating area;
S2: introducing a first gas source into a first pipe and introducing a second gas source into a second pipe after the substrate is placed on the surface of the second heating area, where the second gas source is decomposed into a second decomposed gas above the second heating area, and the first gas source is decomposed into a first decomposed gas above the first heating area;
S3: transporting the first decomposed gas to an area above the second heating area; and
S4: growing a film layer on a surface of the substrate by a reaction between the second decomposed gas and the first decomposed gas above the second heating area.

The operation method of the semiconductor growth device further includes: simultaneously introducing the first gas source into the first pipe and introducing a third gas source into the third pipe, where a group source type of the third gas source is the same as a group source type of the second gas source, and a flow rate for introducing the third gas source into the third pipe is less than a flow rate for introducing the first gas source into the first pipe; and simultaneously introducing the second gas source into the second pipe and introducing a fourth gas source into the fourth pipe, where a group source type of the fourth gas source is the same as a group source type of the first gas source, and a flow rate for introducing the fourth gas source into the fourth pipe is less than a flow rate for introducing the second gas source into the second pipe.

In this embodiment, the method further includes: after the substrate is placed on the surface of the second heating area, rotating the heating base around a central axis of the heating base. In an embodiment, the rotational speed of the heating base ranges from 10 revolutions per minute to 120 revolutions per minute.

Obviously, the foregoing embodiments are merely examples for clear description, rather than a limitation to implementations. For a person of ordinary skill in the art, other changes or variations in different forms may also be made based on the foregoing description. All implementations cannot and do not need to be exhaustively listed herein. Obvious changes or variations that are derived there from still fall within the protection scope of the present application.

## Claims

1. A semiconductor growth device, comprising:
a reaction chamber;
a heating base arranged in the reaction chamber, wherein the heating base comprises a first heating area and a second heating area arranged around a periphery of the first heating area, a heating temperature of the first heating area is greater than a heating temperature of the second heating area, and a surface of the second heating area is adapted for placing a substrate; and
a first spray unit and a second spray unit arranged at a top of the reaction chamber, wherein the second spray unit is arranged around a periphery of the first spray unit, the first spray unit is arranged above the first heating area, and the second spray unit is arranged above the second heating area,
wherein the first spray unit comprises at least a first pipe, the first pipe is adapted for introducing a first gas source, the second spray unit comprises at least a second pipe, the second pipe is adapted for introducing a second gas source, and a decomposition temperature of the first gas source is greater than a decomposition temperature of the second gas source.

2. The semiconductor growth device according to claim 1, further comprising: a first flow rate adjustment member disposed on a transport path of the first pipe; and a second flow rate adjustment member disposed on a transport path of the second pipe.

3. The semiconductor growth device according to claim 1, further comprising: an isolation member disposed at the top of the reaction chamber and arranged between the first spray unit and the second spray unit.

4. The semiconductor growth device according to claim 1, wherein the heating base comprises:
a first subbase, wherein the first subbase comprises a central area and an edge area surrounding the central area, and an accommodating groove is provided in at least a top of the central area; and
a second subbase arranged in the accommodating groove,
wherein the second subbase forms the first heating area, and the first subbase arranged around a periphery of the second subbase forms the second heating area.

5. The semiconductor growth device according to claim 4, wherein a heat insulating member is disposed between the second subbase and the first subbase.

6. The semiconductor growth device according to claim 4 or 5, wherein the accommodating groove is arranged in the top of the central area; and the semiconductor growth device further comprises a rotating shaft, and the rotating shaft is fastened to the first subbase below the second subbase.

7. The semiconductor growth device according to claim 5, wherein the accommodating groove penetrates the central area, the accommodating groove comprises a first subgroove area and a second subgroove area arranged above the first subgroove area, a cross-sectional size of the second subgroove area is greater than a cross-sectional size of the first subgroove area, the heat insulating member is disposed on a groove bottom of the second subgroove area, and the heat insulating member is arranged around the first subgroove area.

8. The semiconductor growth device according to claim 7, wherein the accommodating groove further comprises a third subgroove area arranged below the second subgroove area; and the semiconductor growth device further comprises: a fastening pin arranged in the third subgroove area, wherein the fastening pin is fastened to the first subbase around a periphery of the third subgroove area; and a rotating shaft, wherein the rotating shaft is arranged below the fastening pin and connected to the fastening pin.

9. The semiconductor growth device according to claim 8, wherein the fastening pin is an insulation fastening pin.

10. The semiconductor growth device according to claim 1, wherein a spacing between the first spray unit and the first heating area ranges from 8 mm to 20 mm; and a spacing between the second spray unit and the second heating area ranges from 8 mm to 20 mm.

11. The semiconductor growth device according to claim 1, wherein a material of the heating base comprises graphite or molybdenum.

12. The semiconductor growth device according to claim 1, wherein the first spray unit further comprises a third pipe spaced apart from the first pipe, the third pipe is adapted for introducing a third gas source, a group source type of the third gas source is the same as a group source type of the second gas source, and a flow rate for introducing the third gas source into the third pipe is less than a flow rate for introducing the first gas source into the first pipe; and the second spray unit further comprises a fourth pipe spaced apart from the second pipe, the fourth pipe is adapted for introducing a fourth gas source, a group source type of the fourth gas source is the same as a group source type of the first gas source, and a flow rate for introducing the fourth gas source into the fourth pipe is less than a flow rate for introducing the second gas source into the second pipe.

13. The semiconductor growth device according to claim 12, wherein the first gas source comprises a group-V gas source, and the fourth gas source comprises a group-V gas source; and the second gas source comprises a group-III gas source, and the third gas source comprises a group-III gas source.

14. The semiconductor growth device according to claim 12, wherein the decomposition temperature of the first gas source is greater than or equal to a decomposition temperature of the fourth gas source.

15. The semiconductor growth device according to claim 12, further comprising: a third flow rate adjustment member disposed on a transport path of the third pipe; and a fourth flow rate adjustment member disposed on a transport path of the fourth pipe.

16. The semiconductor growth device according to claim 1, further comprising: a first transition heating area to an N^{th} transition heating area arranged between the first heating area and the second heating area; and a first transition spray unit to an N^{th} transition spray unit arranged between the first spray unit and the second spray unit, wherein N is an integer greater than or equal to 1; and a k^{th} transition spray unit is arranged above a k^{th} transition heating area, and k is an integer greater than or equal to 1 and less than or equal to N.

17. The semiconductor growth device according to claim 1, further comprising: a first radio frequency unit arranged below the first heating area; and a second radio frequency unit arranged below the second heating area, wherein a radio frequency power of the first radio frequency unit is greater than a radio frequency power of the second radio frequency unit.

18. An operation method of the semiconductor growth device according to any one of claims 1 to 17, comprising:
placing a substrate on a surface of a second heating area;
introducing a first gas source into a first pipe and introducing a second gas source into a second pipe after the substrate is placed on the surface of the second heating area, wherein the second gas source is decomposed into a second decomposed gas above the second heating area, and the first gas source is decomposed into a first decomposed gas above the first heating area;
transporting the first decomposed gas to an area above the second heating area; and
growing a film layer on a surface of the substrate by a reaction between the second decomposed gas and the first decomposed gas above the second heating area.

19. The operation method of the semiconductor growth device according to claim 18, wherein the first spray unit further comprises a third pipe spaced apart from the first pipe; and the second spray unit further comprises a fourth pipe spaced apart from the second pipe; and
the operation method of the semiconductor growth device further comprises:
simultaneously introducing the first gas source into the first pipe and introducing a third gas source into the third pipe, wherein a group source type of the third gas source is the same as a group source type of the second gas source, and a flow rate for introducing the third gas source into the third pipe is less than a flow rate for introducing the first gas source into the first pipe; and
simultaneously introducing the second gas source into the second pipe and introducing a fourth gas source into the fourth pipe, wherein a group source type of the fourth gas source is the same as a group source type of the first gas source, and a flow rate for introducing the fourth gas source into the fourth pipe is less than a flow rate for introducing the second gas source into the second pipe.

20. The operation method of the semiconductor growth device according to claim 18, wherein, after the substrate is placed on the surface of the second heating area, the heating base is rotated around a central axis of the heating base.
